# EUROPÄISCHE PATENTSCHRIFT

(11) **EP 3 507 614 B1**
(45) Veröffentlichungstag und Bekanntmachung des Hinweises auf die Patenterteilung: **21.09.2022**
(21) Anmeldenummer: 17719825.6
(22) Anmeldetag: 18.04.2017
(51) Int. Cl.: G01R 31/36, B60L 3/12, B60L 1/00

(54) **VERFAHREN ZUR FESTSTELLUNG DER FUNKTIONSSICHERHEIT EINER BATTERIE**
METHOD FOR DETERMINING THE FUNCTIONAL RELIABILITY OF A BATTERY
PROCÉDÉ DE DÉTERMINATION DE LA SÉCURITÉ DE FONCTIONNEMENT D'UNE BATTERIE

(30) Priorität: 02.09.2016 DE 102016216664
(43) Veröffentlichungstag der Anmeldung: 10.07.2019
(73) Patentinhaber: Volkswagen Aktiengesellschaft, 38440 Wolfsburg (DE)
(72) Erfinder: KREMSER, Till, 37589 Kalefeld (DE); HOLLAS, Markus, 38448 Wolfsburg (DE); NEBELSIEK, Marvin, 38106 Braunschwaig (DE); SAUCKE, Wolfgang, 29378 Wittingen (DE)
(86) Internationale Anmeldenummer: PCT/EP2017/059167
(87) Internationale Veröffentlichungsnummer: WO 2018/041421

(56) Entgegenhaltungen:
- EP-A1- 1 892 536
- DE-A1- 10 109 049
- DE-A1-102011 087 678
- DE-A1-102012 215 755
- DE-A1-102013 221 502
- US-A- 4 361 809

## Beschreibung

Die vorliegende Erfindung betrifft ein Verfahren zur Feststellung der Funktionssicherheit einer Niedervoltbatterie (NV-Batterie) eines zumindest teilweise elektrisch angetriebenen Fahrzeugs, die mit einem Prüfpuls belastet wird.

Herkömmliche motorbetriebene Fahrzeuge besitzen einen Motor und eine Lichtmaschine (Generator), die von dem Motor angetrieben wird und die das Fahrzeug mit elektrischer Energie versorgt. Hierüber werden auch sicherheitsrelevante Systeme, wie beispielsweise der Bremskraftverstärker, die Servolenkung, ESP und die Beleuchtung angetrieben. Zusätzlich weisen solche Fahrzeuge eine Niedervoltbatterie auf, die von der Lichtmaschine aufgeladen wird und die bestimmte Funktionen der Stromversorgung auch bei abgeschaltetem Motor und mithin abgeschalteter Lichtmaschine übernimmt, wie beispielsweise das Radio oder die Fensterheber. In Fällen, in denen die Lichtmaschine aufgrund eines Defektes ausfällt und das Fahrzeug nicht mehr mit elektrischer Energie versorgt werden kann, übernimmt die Niedervoltbatterie die komplette Stromversorgung des Fahrzeugs und insbesondere auch die Stromversorgung der sicherheitsrelevanten Elektroniksysteme, was aufgrund der geringen Kapazität der NV-Batterie nur für einen Notbetrieb des Fahrzeugs und mithin ein rasches Abstellen des Fahrzeugs dienen kann. Insbesondere sicherheitsrelevante Systeme sind häufig große Stromverbraucher, die von daher nur kurzzeitig mit der NV-Batterie betrieben werden können.

Damit jederzeit eine hinreichende Funktionsfähigkeit der NV-Batterie bei einem Ausfall der Lichtmaschine gewährleistet ist, wird in heutigen konventionellen Fahrzeugen regelmäßig der Ladezustand, die Kapazität und die entnehmbare Ladung festgestellt, was eine grobe Abschätzung über die Leistungsfähigkeit und Funktionssicherheit der Batterie erlaubt. Ferner wird bereits beim Startvorgang des Motors die NV-Batterie mit einem elektrischen Puls belastet, so dass empirisch auf eine hinreichende Funktionssicherheit im Falle eines Motorstarts zurückgeschlossen werden kann, was sich millionenfach bewährt hat.

Moderne Elektroautos (BEV-Fahrzeuge) sowie Hybridfahrzeuge (PHEV und mHEV-Fahrzeuge) besitzen neben einer Hochvoltbatterie (HV-Batterie) zur elektrischen Versorgung des Elektromotors und anderer elektrischer Verbraucher mit einem entsprechenden Energieverbrauch auch eine NV-Batterie, die das NV-Bordnetz des Fahrzeugs redundant versorgt. Die sicherheitsrelevanten Systeme werden bei einem fehlerfreien Betrieb des Fahrzeugs üblicherweise durch die HV-Batterie über einen DC/DC Spannungswandler mit der erforderlichen Niedervoltspannung versorgt. In Notfällen und bei einem Ausfall der HV-Batterie oder des Spannungswandlers müssen ähnlich wie bei einem Ausfall der Lichtmaschine in konventionellen Fahrzeugen die sicherheitsrelevanten NV- Systeme auch bei Elektro- und Hybridfahrzeugen von der NV-Batterie versorgt werden. Dementsprechend muss in regelmäßigen Abständen überprüft werden, ob die NV-Batterie die Funktionsanforderung erfüllt, wozu aufgrund fehlender Startvorgänge von etwa vorhandenen Verbrennungsmotoren eine gleichwertige Funktionsdiagnose der NV-Batterie erforderlich ist. Derzeit sind die einschlägigen Sicherheitsanforderungen für die Bordnetzenergieversorgung neu entwickelter Fahrzeugprojekte in ISO 26262, ASIL A von B normiert. Diesen Sicherheitsanforderungen müssen Bordnetzenergieversorgungssysteme genügen.

Es gibt bereits verschiedene Verfahren für eine Funktionsdiagnose bei NV-Batterien. Beispielsweise wird in DE 10 2013 221 502 A1 ein Verfahren zur Erzeugung eines Prüfpulses für eine Batterie in einem Kraftfahrzeugbordnetz mit elektrischen Verbrauchern (V1, V2, ...Vx) vorgeschlagen, wobei das Verfahren umfasst:
- Auswählen einer Gruppe von elektrischen Verbrauchern (V1, V2,...Vx), die zur Erzeugung eines Prüfpulses beitragen sollen; und
- Aktivieren der ausgewählten elektrischen Verbraucher (V1, V2,...Vx) zu einem oder mehreren vorgegebenen Zeitpunkten.

Das beschriebene Verfahren offenbart jedoch nicht, wie aus der Last des Prüfpulses auf die Funktionssicherheit der Batterie zurückgeschlossen werden kann.

Auch EP 1 892 536 A1 fordert eine Überwachung des Alterungszustandes (SoH), des Ladezustandes (SoC) und des Grads der Funktionserfüllung (SoF), wozu eine Impedanzspektroskopie durchgeführt wird. Bei der Impedanzspektroskopie wird die Batterie nicht belastet, so dass das Verfahren lediglich für die Bestimmung des Betriebszustandes, d.h. Ladungszustand und Alterungszustand geeignet ist. Beide Größen werden durch die aktuell entnehmbare Kapazität bzw. die maximal im Volladezustand entnehmbare Kapazität bei einem geringen Laststrom und bei definierter Temperatur berechnet. Für Blei-Akkumulatoren ist beispielsweise EN50342-1 einschlägig. Da sich Energiespeicher abhängig vom Laststrom und der Temperatur stark nichtlinear verhalten (vgl. Peukert-Gleichung für Blei-Batterien im Neuzustand) und sich dieses Verhalten abhängig von einer Vielzahl von Alterungsfaktoren (insbesondere Korrosion, Ladungsdurchsatz, Nutzungsprofil des Kunden) über die Lebenszeit der Batterie kontinuierlich verändert, ist die Vorhersage des Grades der Funktionserfüllung auf Grundlage der Normgrößen SOC und SOH nur unzureichend möglich. Insbesondere für hohe Lastströme ist das beschriebene Verfahren ungeeignet.

Ein weiteres Verfahren zur Feststellung der Funktionssicherheit einer Batterie wird in DE 102012215755 A1 angesprochen. Hierzu werden Betriebsparameter der Batterie bestimmt, worunter Größen wie beispielsweise Ruhespannung, Innenwiderstand, Impedanz, Ladezustand, Kapazität und dergleichen zu verstehen sind.

DE 10109049 A1 beschreibt zwar ein Funktionstest einer Fahrzeugbatterie mittels eines Prüfpulses, allerdings ist das Verfahren nur auf motorbetriebene Fahrzeuge beschränkt, bei denen bekanntlich Prüfpulse erzeugbar sind, die eine zu Notfallpulsen vergleichbare Stromstärke aufweisen.

Ferner wird in US 4,361,809 ein Verfahren zum Testen einer Batterie vorgeschlagen, wonach bestimmte Eigenschaften aus Entlade- und Ladezyklen abgeleitet werden.

Schließlich offenbart DE 102011087678 A1 eine Vorrichtung zur Erfassung des Zustandes eines zu prüfenden Akkumulators eines Fahrzeugs mit mindestens zwei Fahrzeugbordnetzen unterschiedlicher Betriebsspannungen, wobei der Akkumulator über einen DC/DC-Wandler mit Testpulsen beaufschlagt wird und die Reaktionswerte eine Erfassung des Zustandes des Akkumulators erlauben.

Nachteilig an dem bekannten Stand der Technik ist, dass die Funktionserfüllung von Batterien nur unzureichend mit den offenbarten Verfahren festgestellt werden kann.

Es ist daher die Aufgabe der vorliegenden Erfindung, ein Verfahren vorzuschlagen, das mit einfachen Mitteln eine Funktionsüberprüfung erlaubt, die aufzeigt, dass die Batterie ein vorgebbares Belastungsszenario erfüllen wird, ohne während des Belastungsszenarios eine temperaturunabhängige Spannungsuntergrenze zu unterschreiten.

Diese Aufgabe wird durch das Verfahren nach Anspruch 1 gelöst. Erfindungsgemäß ist vorgesehen, dass der Prüfpuls eine Stromstärke aufweist, die geringer als die Stromstärke ist, die zur Durchführung eines Notfallpulses erforderlich ist, wobei der Notfallpuls ein Anforderungsprofil für die NV-Batterie darstellt, das die NV-Batterie erfüllen muss, um bei einem Ausfall einer Hochvoltbatterie (HV-Batterie) sicherheitsrelevante Elektroniksysteme zumindest zeitweise versorgen zu können, damit das Fahrzeug zumindest sicher abgestellt werden kann, wobei sich die Funktionssicherheit der NV-Batterie aus einer Korrelation des sich während des Prüfpulses ergebenden Spannungsverlaufes an der NV-Batterie mit einer vorgegebenen Funktionsanforderung ergibt und die Funktionssicherheit gegeben ist, wenn der Spannungsverlauf der NV-Batterie während des Prüfpulses mehreren Prüfkriterien genügt, die vor dem Prüfpuls (21) zur Zeit to, am Ende des Prüfpulses zur Zeit t₁ und in der Mitte des Prüfpulses (21) zur Zeit t_{0,5} erfüllt sein müssen, wonach
a) die Spannung am Ende des Prüfpulses einen vorgegebenen Grenzwert nicht unterschreiten darf,
b) ein Spannungsgradient zwischen den Zeitpunkten t_{0,5} und t₁ des Prüfpulses einen vorgegebenen Grenzwert nicht unterschreiten darf und
c) eine Spannungsdifferenz zwischen der Spannung vor dem Prüfpuls zur Zeit t₀ und einer Spannung am Ende des Prüfpulses zum Zeitpunkt t₁ einen vorgegebenen Grenzwert nicht überschreiten darf.

Die vorliegende Erfindung ermöglicht unabhängig von der unmittelbaren Vorbehandlung der NV-Batterie beziehungsweise von deren aktueller Spannung eine Korrelation zwischen dem Spannungsverlauf der NV-Batterie während der Belastung mit einem Prüfpuls und der späteren Anforderung an die NV-Batterie, ein definiertes Belastungsszenario ohne Unterschreiten einer Spannungsuntergrenze zu bewältigen.

Bevorzugte Ausführungsformen der vorliegenden Erfindung werden im Folgenden und in den Unteransprüchen erläutert.

Weil Fahrzeuge in Temperaturbereichen nicht selten zwischen -20°C und +40°C zuverlässig funktionieren müssen, ist vorzugsweise vorgesehen, dass die Prüfkriterien temperaturabhängig sind, indem die Spannung am Ende des Prüfpulses und/oder der Spannungsgradient zwischen den Zeitpunkten t_{0,5}, t₁ des Prüfpulses und/oder die Spannungsdifferenz zwischen der Spannung vor dem Prüfpuls und einer Spannung am Ende des Prüfpulses temperaturabhängig festgelegt sind.

Die Funktionssicherheit der Batterie ist nur dann gegeben, wenn alle Prüfkriterien a), b) und c) erfüllt sind.

Vorzugsweise wird der belastende Prüfpuls für eine Pulsdauer von 10 s bis 30 s, vorzugsweise 19 s bis 23 s aufrechterhalten. Als besonders bevorzugt hat sich dabei herausgestellt, dass der Prüfpuls zumindest zeitweise und für eine Pulsdauer von mehr als 9 s eine Stromstärke von 80 A bis 130 A, vorzugsweise von 90 A bis 100 A aufweist. Dabei steigt die Stromstärke während des Prüfpulses stufenweise an, bevor die Stromstärke ihren Maximalwert von 80 A bis 130 A erreicht hat.

Nach einer besonders bevorzugten Ausführungsform ist vorgesehen, dass der Prüfpuls vollständig oder zumindest teilweise mittels eines DC/DC-Wandlers erzeugt wird, der die aus der NV-Batterie entnommene elektrische Energie vollständig oder anteilig in die Hochvoltbatterie (HV-Batterie) des Fahrzeugs einlädt, wodurch sich der Verlust elektrischer Energie durch den Prüfpuls reduziert.

Das dargelegte Verfahren ermöglicht unmittelbar nach dem Prüfpuls eine Ja/Nein-Aussage, ob die Batterie die geforderte Funktionssicherheit erfüllt oder nicht. Bei der Festlegung der temperaturunabhängigen Spannungsuntergrenze der Funktionsanforderung wird der Wert ermittelt, der für die Erfüllung der Funktionsanforderung nicht unterschritten werden darf.

Eine Überschreitung der temperaturabhängig festgelegten Grenzwerte des Prüfpulses hängt von der Leistungsfähigkeit der NV-Batterie ab, denn je leistungsfähiger die NV-Batterie ist, desto größer sind die aktiven Elektrodenoberflächen bzw. desto geringer ist die Stromdichte bei Belastung und damit der Spannungseinbruch. Je größer der fließende Strom ist, desto stärker unterscheiden sich unterschiedlich performante NV-Batterien in ihren Stromdichten beziehungsweise Spannungseinbrüchen, die zur Bewertung der Funktionsfähigkeit herangezogen werden können.

Das erfindungsgemäße Verfahren wird nachfolgend und anhand eines konkreten Ausführungsbeispiels mit Hinweis auf die Figuren erläutert. Es zeigen:
- Fig. 1: eine schematische Darstellung der Energieversorgung eines Elektrofahrzeugs,
- Fig. 2: einen möglichen Prüfpuls und einen Notfallpuls innerhalb eines Diagramms und
- Fig. 3a-c: mögliche Spannungsverläufe während des Prüfpulses und einen Spannungsverlauf während eines Funktionspulses innerhalb jeweils eines Diagramms.

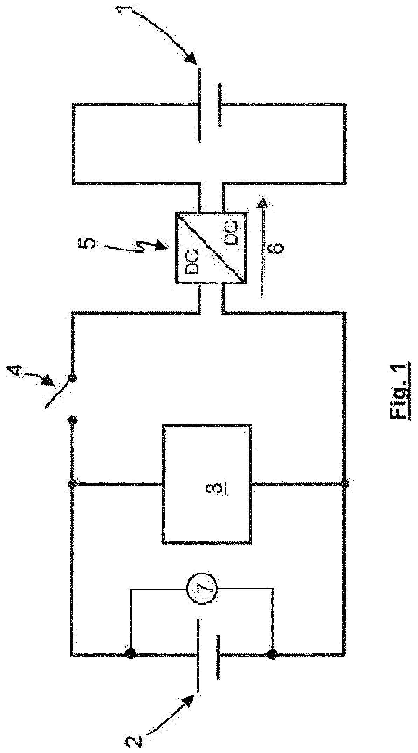

Fig. 1 zeigt eine mögliche Vorrichtung, mit der das erfindungsgemäße Verfahren angewendet werden kann. Dargestellt ist die Energieversorgung eines (nicht dargestellten) Elektrofahrzeugs mit einer HV-Batterie 1 und einer NV-Batterie 2, die das NV-Bordnetz 3 des Fahrzeugs versorgt. Die NV-Batterien 1, 2 können Blei-Akkumulatoren, Lithium-Akkumulatoren oder sonstige geeignete NV-Batterien sein. Üblicherweise ist das Bordnetz von derzeit gängigen PKWs auf 12 V und das Bordnetz von herkömmlichen LKWs auf 24 V ausgelegt. Es sind jedoch auch andere Bordnetzspannungen im NV-Bereich von beispielsweise 12 V bis 60 V umsetzbar. Um die NV-Batterie 2 mit einem Prüfpuls zu beaufschlagen, ist ein Schalter 4 vorgesehen, der die NV-Batterie 2 mit einem DC/DC-Wandler 5 verbindet und der für eine Rückspeisung der elektrischen Energie im Hochsetzbetrieb in die HV-Batterie 1 sorgt (Pfeil 6). Sobald der Schalter 4 geschlossen wird, wird die NV-Batterie 2 mit dem Prüfpuls beaufschlagt und die Spannung an der NV-Batterie wird mittels eines Voltmeters 7 gemessen. Der Spannungsverlauf kann unmittelbar in Korrelation mit einem Funktionspuls gesetzt werden, so dass sich eine eindeutige Aussage über die Funktionssicherheit der NV-Batterie 2 ergibt.

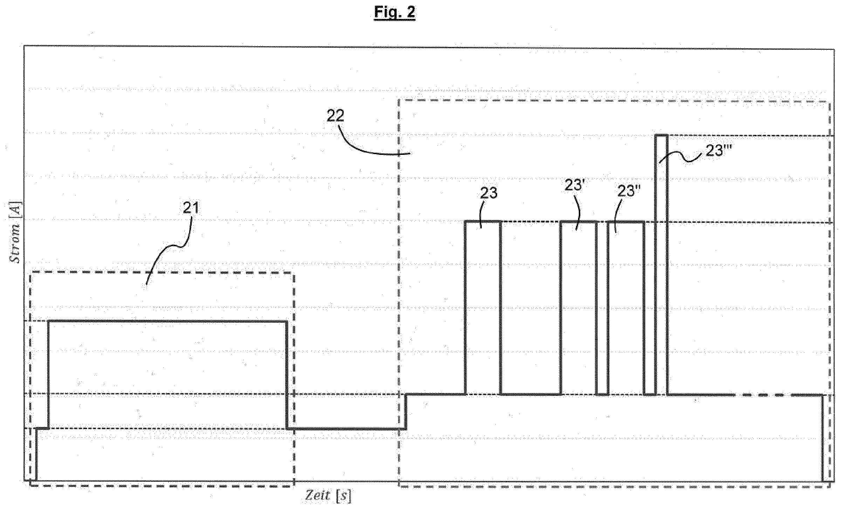

Fig. 2 zeigt innerhalb eines Liniendiagramms den Verlauf der Stromstärke A eines Prüfpulses 21 (linke Seite) und eines Notfallpulses 22 (rechte Seite) in Abhängigkeit von der Zeit t. Der Notfallpuls 22 ist nur beispielhaft skizziert und besteht aus einer Folge von rechteckförmigen Strompulsen 23, 23', 23", 23‴ unterschiedlicher Stromstärke und unterschiedlicher Dauer. Der Notfallpuls 22 stellt ein Anforderungsprofil für die NV-Batterie 2 dar, das die NV-Batterie 2 mindestens erfüllen muss, um beim Ausfall der HV-Batterie 1 sicherheitsrelevante Elektroniksysteme zumindest zeitweise versorgen zu können, damit das Fahrzeug zumindest sicher abgestellt werden kann.

Um die Funktionssicherheit der NV-Batterie zu überprüfen, wird die NV-Batterie regelmäßig mit einem Prüfpuls 21 belastet, wie er auf der linken Seite des Liniendiagramms in Fig. 2 dargestellt ist. Der gezeigte Prüfpuls 21 steigt stufenweise auf eine Stromstärke von ca. 95 A an und dauert im dargestellten Ausführungsbeispiel ca. 22 s.

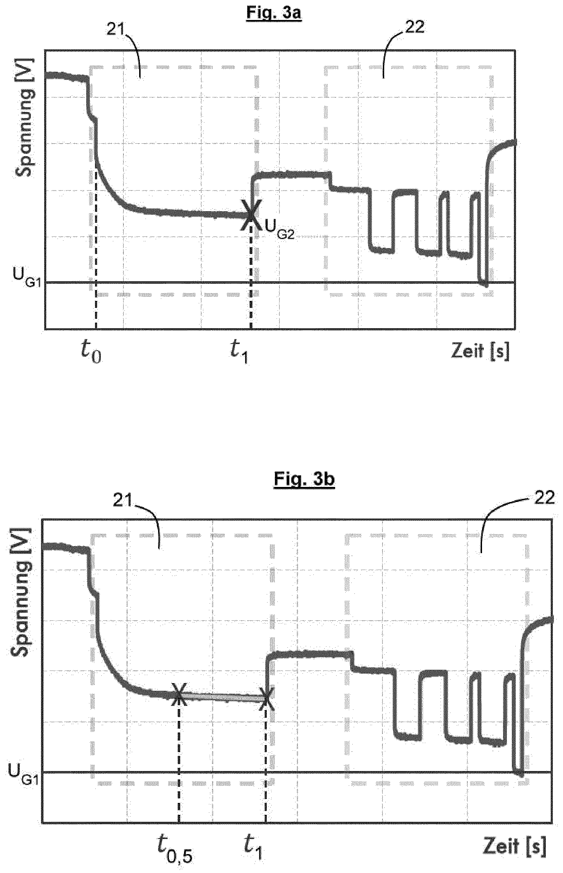

Die Fig. 3a-c zeigen den sich aus den Pulsen ergebenden Spannungsverlauf an der NV-Batterie. Im rechten Teil der Diagramme sind jeweils Funktionspulse gezeigt, also der Spannungsverlauf, der sich an der NV-Batterie ergibt, wenn eine bestimmte Funktion durchgeführt wird. Die Funktionssicherheit der NV-Batterie ist dann gegeben, wenn der Spannungsverlauf während des Funktionspulses eine Spannungsuntergrenze U_{G1} nicht unterschreitet, was im gezeigten Ausführungsbeispiel gerade noch zutrifft.

Auf der jeweils linken Seite ist der Spannungsverlauf während des Prüfpulses dargestellt. Das erfindungsgemäße Verfahren erlaubt nunmehr eine Vorhersage aus dem konkreten Spannungsverlauf während des Prüfpulses, ob ein späterer Funktionspuls ohne Unterschreiten der Grenzspannung U_{G1} durchgeführt werden kann oder nicht. Hierzu sind verschiedene Prüfkriterien zu erfüllen, die in den Fig. 3a-c gezeigt sind.

Ein erstes Prüfkriterium schreibt vor, dass die Spannung U_{G2} am Ende des Prüfpulses einen temperaturabhängigen Grenzwert nicht unterschreiten darf, der auch von der NV-Batterie abhängt und zuvor festzulegen ist.

Ein zweites Prüfkriterium betrifft einen Spannungsgradienten zwischen zwei Zeitpunkten des Prüfpulses. Im dargestellten Ausführungsbeispiel sind beispielhaft die Zeiten t_{0,5} und t₁ gezeigt. Die linear abfallende Steigung zwischen diesen Punkten darf ebenfalls einen temperaturabhängigen und vorzugebenden Grenzwert nicht unterschreiten.

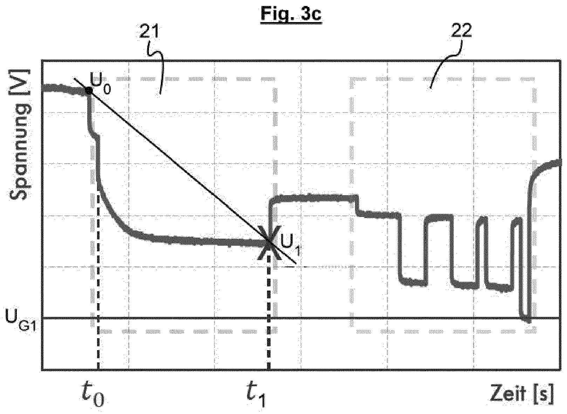

Schließlich ist als drittes Prüfkriterium vorgesehen, dass eine Spannungsdifferenz (Spannungsdelta) zwischen der Spannung Uo vor dem Prüfpuls und der minimalen Spannung während des Prüfpulses U₁ einen vorgegebenen Grenzwert nicht unterschreiten darf. Im dargestellten Ausführungsbeispiel der Fig. 3c ist diese Spannungsdifferenz durch den Anfangswert der Spannung Uo und dem Endwert der Spannung U₁ während des Prüfpulses gegeben.

Wenn alle drei Prüfkriterien erfüllt sind, ist sichergestellt, dass eine hinreichende Funktionssicherheit von der NV-Batterie gewährleistet ist. Anderenfalls ist ein entsprechender Warnhinweis abzugeben.

### Bezugszeichenliste

- 1: HV-Batterie
- 2: NV-Batterie
- 3: Bordnetz
- 4: Schalter
- 5: DC/DC-Wandler
- 6: Pfeil (Rückspeisung)
- 7: Voltmeter

## Patentansprüche

1. Verfahren zur Feststellung der Funktionssicherheit einer Niedervoltbatterie, NV-Batterie, (2) eines zumindest teilweise elektrisch angetriebenen Fahrzeugs, die mit einem Prüfpuls (21) belastet wird, **dadurch gekennzeichnet, dass** der Prüfpuls (21) eine Stromstärke aufweist, die geringer als die Stromstärke ist, die zur Durchführung eines Notfallpulses (22) erforderlich ist, wobei der Notfallpuls (22) ein Anforderungsprofil für die NV-Batterie (2) darstellt, das die NV-Batterie (2) erfüllen muss, um bei einem Ausfall einer Hochvoltbatterie, HV-Batterie, (1) sicherheitsrelevante Elektroniksysteme zumindest zeitweise versorgen zu können, damit das Fahrzeug zumindest sicher abgestellt werden kann, wobei sich die Funktionssicherheit der NV-Batterie (2) aus einer Korrelation des sich während des Prüfpulses (21) ergebenden Spannungsverlaufes an der NV-Batterie (2) mit einer vorgegebenen Funktionsanforderung ergibt und die Funktionssicherheit gegeben ist, wenn der Spannungsverlauf der NV-Batterie (2) während des Prüfpulses (21) mehreren Prüfkriterien genügt, die vor dem Prüfpuls (21) zur Zeit to, am Ende des Prüfpulses zur Zeit t₁ und in der Mitte des Prüfpulses (21) zur Zeit t_{0,5} erfüllt sein müssen, wonach
a) die Spannung am Ende des Prüfpulses (21) einen vorgegebenen Grenzwert U_{G} nicht unterschreiten darf,
b) ein Spannungsgradient zwischen den Zeitpunkten t_{0,5} und t₁ des Prüfpulses (21) einen vorgegebenen Grenzwert nicht unterschreiten darf und
c) eine Spannungsdifferenz zwischen der Spannung vor dem Prüfpuls (21) zur Zeit to und einer Spannung am Ende des Prüfpulses (21) zum Zeitpunkt t₁ einen vorgegebenen Grenzwert nicht überschreiten darf.

2. Verfahren nach Anspruch 1, **dadurch gekennzeichnet, dass** die Prüfkriterien temperaturabhängig sind, indem die Spannung am Ende des Prüfpulses (21) und/oder der Spannungsgradient zwischen den Zeitpunkten t_{0,5} und t₁ des Prüfpulses (21) und/oder die Spannungsdifferenz zwischen der Spannung vor dem Prüfpuls (21) und einer Spannung am Ende des Prüfpulses (21) temperaturabhängig festgelegt sind.

3. Verfahren nach einem der Ansprüche 1 oder 2, **dadurch gekennzeichnet, dass** der Prüfpuls (21) für eine Pulsdauer von 10 s bis 30 s, vorzugsweise von 19 s bis 23 s aufrechterhalten wird.

4. Verfahren nach einem der Ansprüche 1 bis 3, **dadurch gekennzeichnet, dass** der Prüfpuls (21) zumindest zeitweise und für eine Pulsdauer von mehr als 9 s eine Stromstärke von 80 A bis 130 A, vorzugsweise von 90 A bis 100 A aufweist.

5. Verfahren nach einem der Ansprüche 1 bis 4, **dadurch gekennzeichnet, dass** die Stromstärke des Prüfpulses (21) stufenweise ansteigt, bevor die Stromstärke von 80 A bis 130 A erreicht ist.

6. Verfahren nach einem der Ansprüche 1 bis 5, **dadurch gekennzeichnet, dass** der Prüfpuls (21) vollständig oder zumindest teilweise mittels eines DC/DC-Wandlers (5) erzeugt wird, der die aus der NV-Batterie (2) entnommene elektrische Energie vollständig oder anteilig in die HV-Batterie (1) des Fahrzeugs einlädt.

## Claims

1. Method for determining the functional reliability of a low-voltage battery, LV battery, (2) of an at least partly electrically driven vehicle, to which battery a test pulse (21) is applied, **characterized in that** the test pulse (21) has a current intensity that is lower than the current intensity required to carry out an emergency pulse (22), wherein the emergency pulse (22) constitutes a request profile for the LV battery (2) that the LV battery (2) has to satisfy in order to be able to at least temporarily supply power to safety-relevant electronics systems in the event of a failure of a high-voltage battery, HV battery, (1) in order that the vehicle can at least be parked safely, wherein the functional reliability of the LV battery (2) results from a correlation of the voltage profile on the LV battery (2), resulting during the test pulse (21), together with a specified function request and there is functional reliability if the voltage profile of the LV battery (2) during the test pulse (21) meets a plurality of test criteria that have to be satisfied before the test pulse (21) at the time t₀, at the end of the test pulse at the time t₁ and in the middle of the test pulse (21) at the time t_{0.5}, according to which
a) the voltage at the end of the test pulse (21) may not and a predetermined limit value U_{G},
b) a voltage gradient between the times t_{0.5} and t₁ of the test pulse (21) may not undershoot a predetermined limit value and
c) a voltage difference between the voltage before the test pulse (21) at the time t₀ and a voltage at the end of the test pulse (21) at the time t₁ may not exceed a predetermined limit value.

2. Method according to Claim 1, **characterized in that** the test criteria are dependent on temperature **in that** the voltage at the end of the test pulse (21) and/or the voltage gradient between the times t_{0.5} and t₁ of the test pulse (21) and/or the voltage difference between the voltage before the test pulse (21) and a voltage at the end of the test pulse (21) are determined in a manner dependent on temperature.

3. Method according to either one of Claims 1 or 2, **characterized in that** the test pulse (21) is maintained for a pulse duration of 10 s to 30 s, preferably of 19 s to 23 s.

4. Method according to any one of Claims 1 to 3, **characterized in that** the test pulse (21) has a current intensity of 80 A to 130 A, preferably of 90 A to 100 A, at least temporarily and for a pulse duration of more than 9 s.

5. Method according to any one of Claims 1 to 4, **characterized in that** the current intensity of the test pulse (21) increases incrementally before the current intensity of 80 A to 130 A is reached.

6. Method according to any one of Claims 1 to 5, **characterized in that** the test pulse (21) is generated fully or at least partly by means of a DC-DC converter (5) that fully or partially loads the electrical energy drawn from the LV battery (2) into the HV battery (1) of the vehicle.

## Revendications

1. Procédé permettant de déterminer la sécurité de fonctionnement d'une batterie basse tension, batterie BT, (2) d'un véhicule à propulsion au moins partiellement électrique, qui est sollicitée par une impulsion de contrôle (21),
**caractérisé en ce que** l'impulsion de contrôle (21) présente une intensité de courant qui est inférieure à l'intensité de courant qui est nécessaire à l'exécution d'une impulsion de secours (22), l'impulsion de secours (22) représentant un profil d'exigences pour la batterie BT (2) que la batterie BT (2) doit satisfaire (2) afin de pouvoir alimenter au moins temporairement des systèmes électroniques de sécurité en cas de défaillance d'une batterie haute tension, batterie HT, (1) afin que le véhicule puisse au moins être garé en sécurité, la sécurité de fonctionnement de la batterie BT (2) résultant d'une corrélation de la courbe de tension produite pendant l'impulsion de contrôle (21) au niveau de la batterie HT (2) avec une exigence de fonctionnement prédéfinie, et la sécurité de fonctionnement est avérée si la courbe de tension de la batterie BT (2) satisfait pendant l'impulsion de contrôle (21) plusieurs critères de contrôle qui sont à satisfaire avant l'impulsion de contrôle (21) à l'instant t₀, à la fin de l'impulsion de contrôle à l'instant t₁ et au milieu de l'impulsion de contrôle (21) à l'instant t_{0,5}, après quoi
a) la tension à la fin de l'impulsion de contrôle (21) ne doit pas être inférieure à une valeur limite prédéfinie U_{G},
b) un gradient de tension entre les instants t_{0,5} et t₁ de l'impulsion de contrôle (21) ne doit pas être inférieur à une valeur limite prédéfinie, et
c) une différence de tension entre la tension avant l'impulsion de contrôle (21) à l'instant t₀ et une tension à la fin de l'impulsion de contrôle (21) à l'instant t₁ ne doit pas dépasser une valeur limite prédéfinie.

2. Procédé selon la revendication 1, **caractérisé en ce que** les critères de contrôle sont dépendants de la température **en ce que** la tension à la fin de l'impulsion de contrôle (21) et/ou le gradient de tension entre les instants t_{0,5} et t₁ de l'impulsion de contrôle (21) et/ou la différence de tension entre la tension de l'impulsion de contrôle (21) et une tension à la fin de l'impulsion de contrôle (21) sont définis en fonction de la température.

3. Procédé selon l'une quelconque des revendications 1 ou 2, **caractérisé en ce que** l'impulsion de contrôle (21) est maintenue pendant une durée d'impulsion de 10 s à 30 s, de préférence de 19 s à 23 s.

4. Procédé selon l'une quelconque des revendications 1 à 3, **caractérisé en ce que** l'impulsion de contrôle (21) présente au moins temporairement et pendant une durée d'impulsion de plus de 9 s une intensité de courant de 80 A à 130 A, de préférence de 90 A à 100 A.

5. Procédé selon l'une quelconque des revendications 1 à 4, **caractérisé en ce que** l'intensité de courant de l'impulsion de contrôle (21) augmente progressivement avant que l'intensité de courant n'atteigne de 80 A à 130 A.

6. Procédé selon l'une quelconque des revendications 1 à 5, **caractérisé en ce que** l'impulsion de contrôle (21) est générée entièrement ou du moins partiellement au moyen d'un convertisseur à courant continu (5) qui injecte l'énergie électrique prélevée sur la batterie BT (2) entièrement ou proportionnellement dans la batterie HT (1) du véhicule.
